# EUROPEAN PATENT APPLICATION

(11) **EP 1 703 549 A1**
(43) Date of publication of application: **20.09.2006**
(21) Application number: 04820494.5
(22) Date of filing: 18.11.2004
(51) Int. Cl.: H01L 21/205

(54) **VAPOR GROWTH DEVICE AND PORDUCTION METHOD FOR EPITAXIAL WAFER**

(30) Priority: 17.12.2003 JP 2003419202
(71) Applicant: SHIN-ETSU HANDOTAI COMPANY LIMITED, Chiyoda-ku Tokyo 100-0005 (JP)
(72) Inventor: YAMADA, Toru, c/o Shin-Etsu Handotai Co., Ltd., Annaka-shi, Gunma 3790196 (JP); YAGI, Shinichiro, c/o Shin-Etsu Handotai Co., Ltd., Nakanoya (JP)
(74) Representative: Merkle, Gebhard
(86) International application number: PCT/JP2004/017192
(87) International publication number: WO 2005/059980

(57) **Abstract**

A vapor growth device which is constituted as a single-wafer type and has a gas introducing port through which a material gas is led into a reaction vessel. A dam member is disposed around a susceptor, and the material gas from the gas introducing port hits the outer peripheral surface of the dam ring and rides on an upper surface side, and then is allowed to flow along the main surface of a silicon single-crystal substrate placed on the susceptor. Guide plates for dividing the flow in the width direction of the material gas are disposed on the upper surface of the dam member. Accordingly, a vapor growth device capable of controlling the flow rate of material gas flowing on a silicon single-crystal substrate, and a production method for an epitaxial wafer using it are provided.

## Description

### BACKGROUND OF THE INVENTION

### [Field of the Invention]

This invention relates to a vapor phase growth apparatus allowing vapor phase growth of a silicon single crystal film on the main surface of a silicon single crystal substrate to proceed therein, and a method of fabricating an epitaxial wafer realized using the same.

### [Description of the Related Art]

Silicon epitaxial wafer having a silicon single crystal film (simply referred to as "film", hereinafter) grown in vapor phase on the main surface of a silicon single crystal substrate (simply referred to as "substrate", hereinafter) is widely used for electronic devices such as bipolar IC, MOS-IC and so forth. With advancement in micronization of the electronic devices, requirement for flatness of the main surface of the epitaxial wafer in which the devices are fabricated has been becoming more stringent. Causal factors affecting the flatness include flatness of the substrate and distribution of the film thickness. In recent years, single-wafer-type vapor phase growth apparatus has become a mainstream in fabrication of epitaxial wafers having a diameter of 200 mm or more, in place of batch processing of a plurality of wafers. The apparatus holds a single substrate in a horizontally rotating manner in a reaction vessel, while allowing a source gas to flow from one end to the other end of the reaction vessel in a horizontal and unidirectional manner, to thereby proceed vapor phase growth of the film.

One important factor in view of making the resultant film thickness uniform in the above-described, single-wafer-type vapor phase growth apparatus is flow rate, or flow route of the source gas in the reaction vessel. The single-wafer-type vapor phase growth apparatus is generally configured as introducing the source gas through a gas supply duct and through a gas introducing port formed on one end of the reaction vessel, allowing the source gas to flow along the surface of a substrate, and discharging the source gas through a discharging port on the other end of the vessel. In order to reduce non-uniformity in the flow rate in thus-configured vapor phase growth apparatus, proposals have been made on an apparatus having a dispersion plate with a large number of throughholes formed therein disposed on the downstream side of the gas introducing port, and an apparatus having disposed therein a partition plate partitioning the gas flow in the width-wise direction.

Japanese Laid-Open Patent Publication "Tokkaihei" No. 7-193015 discloses a configuration of an apparatus allowing source gas supplied through a gas introducing port to flow towards an outer peripheral surface of a bank component disposed around a susceptor holding a substrate, so as to supply the source gas onto the surface of the substrate after climbing up the bank component. A basic concept of this method is to diffuse the source gas by allowing the flow thereof to collide against the outer peripheral surface of the bank component, to thereby resolve non-uniformity in the flow rate. Another proposal has been made on this sort of vapor phase growth apparatus having the bank component improved so as to allow the source gas to flow more smoothly towards the susceptor (Japanese Laid-Open Patent Publication "Tokkai" No. 2002-231641). Still another proposal has been made on the vapor phase growth apparatus improved so as to intentionally make variation in the flow of the source gas on both sides of the susceptor (Japanese Laid-Open Patent Publication "Tokkai" No. 2002-198316).

Typical known problems in the vapor phase epitaxial growth of the silicon single crystal film on the silicon single crystal substrate include deformation of a pattern. Several factors affecting the pattern deformation have been known, wherein the degree of pattern deformation can be reduced generally by lowering pressure in the reaction vessel so as to increase a diffusion coefficient of HCl gas produced on the surface of the substrate, to thereby depress the etching action by the HCl gas. For this reason, a reduced pressure condition is preferably applicable to vapor phase growth on the silicon single crystal substrate having patterns already formed thereon.

Epitaxial growth under a reduced pressure condition using the apparatus such as described in the aforementioned Japanese Laid-Open Patent Publication "Tokkaihei" No. 7-193015 may, however, sometimes encounters a difficulty in obtaining a desired distribution of film thickness.

It is therefore an object of this invention to provide a vapor phase growth apparatus capable of controlling the flow route of the source gas flowing over the silicon single crystal substrate in order to ensure a desirable distribution of film thickness, and a method of fabricating an epitaxial wafer using the same.
Patent Document 1: Japanese Laid-Open Patent Publication "Tokkaihei" No. 7-193015;
Patent Document 2: Japanese Laid-Open Patent Publication "Tokkai" No. 2002-231641; and
Patent Document 3: Japanese Laid-Open Patent Publication "Tokkai" No. 2002-198316.

### SUMMARY OF THE INVENTION

This invention was conceived aiming at solving the above-described problems so as to provide a vapor phase growth apparatus allowing vapor phase growth of a silicon single crystal film on the main surface of a silicon single crystal substrate to proceed therein, wherein the principal features reside in having a reaction vessel having a gas introducing port formed on a first end side in the horizontal direction, and having a gas discharging port on a second end side in the same direction, configured as allowing a source gas for forming the silicon single crystal film to be introduced through the gas introducing port into the reaction vessel, and to flow along the main surface of the silicon single crystal substrate held in a near-horizontally rotating manner in the inner space of the reaction vessel, and to be discharged through the gas discharging port, the silicon single crystal substrate being disposed on a disc-formed susceptor rotated in the inner space, and having a bank component disposed so as to surround the susceptor, and kept in a positional relation so as to align the top surface thereof at an almost same level with the top surface of the susceptor, and further configured so that the gas introducing port is opened so as to oppose to a outer peripheral surface of the bank component, so as to allow the source gas supplied through the gas introducing port to collide against the outer peripheral surface of the bank component and to climb up onto the top surface side thereof, and then to flow along the main surface of the silicon single crystal substrate on the susceptor, wherein, assuming a virtual center line along the direction of flow of the source gas, extending from the first end of the reaction vessel towards the second end, while crossing normal to the axis of rotation of the susceptor, as the horizontal standard line, and also assuming the direction normal to both of the axis of rotation of the susceptor and the horizontal standard line as the width-wise direction, a guide component dividing the flow of the source gas in the width-wise direction is disposed on the top surface of the bank component.

In the vapor phase growth apparatus of this invention, the guide component for the source gas is disposed on the top surface of the bank component. The source gas climbing up onto the top surface of the bank component is largely limited in the flow thereof in the width-wise direction by the guide component. Because the flow route in the width-wise direction of the source gas flowing over the substrate placed just downstream of the bank component can thus be controlled by partitioning the flow of the source gas directed towards the susceptor in the width-wise direction on the top surface of the bank component, it is made possible to obtain a silicon single crystal film having a more uniform distribution of the film thickness.

In one preferred embodiment, the guide component is configured so as to prevent the source gas from approaching the horizontal standard line. Because the bank component is formed with a cylindrical geometry so as to surround the disk-formed susceptor, the source gas colliding against the outer peripheral surface of the bank component and climbing up onto the top surface thereof tends to flow as being attracted towards the center of the substrate, or as approaching the horizontal standard line. Prevention or suppression of the source gas from approaching the horizontal standard line with the aid of the guide component in this invention is therefore successful in improving the flow route of the source gas.

More specifically, the guide component can be configured by a guide plate dividing the flow of the source gas into sides closer to, and more distant from the horizontal standard line. By adjusting modes of disposition (location of disposition, direction of disposition, the number of plates, thickness of the guide plate, and so forth) of the guide plate, the source gas can be controlled in a relatively easy manner so as to maximize the effect of controlling the direction of flow thereof.

The guide plate is preferably disposed so as to align the plate surface thereof in parallel with the axis of rotation of the susceptor and with the horizontal standard line. Such placement of the guide plate, not strongly obstructing the direction of flow of the source gas, is less likely to cause disturbance in the gas flow, so that it becomes easy to make the flow route of the source gas climbing up onto the top surface of the bank component uniform.

It is also preferable that a gas introducing component, introducing the source gas supplied through the gas introducing port towards the outer peripheral surface of the bank component, is disposed between the gas introducing port and the bank component as being symmetrically distributed with respect to the horizontal standard line in the width-wise direction, the gas introducing component having, in each of gas introducing spaces formed inside thereof, a gas-introducing-component-side partition plate partitioning the flow of the source gas in the width-wise direction, and having, on the outer peripheral surface of the bank component, a bank-component-side partition plate, partitioning the flow of the source gas into a plurality of streams in the width-wise direction, disposed as being symmetrically distributed with respect to the horizontal standard line. This configuration can make control of the flows in the width-wise direction also for the source gas flowing on the upstream side of the bank component and the source gas flowing likely to climb up onto the bank component, so that a synergistic effect as being combined with the guide plate disposed on the top surface of the bank component is expectable.

More specifically, an exemplary mode of embodiment can be given as that the guide plate is disposed outside the locations of the bank-component-side partition plate and the gas-introducing-component- side partition plate disposed, in the width-wise direction. The source gas flowing more further in the outer region in the width-wise direction tends to reach the susceptor, after being largely deflected in the direction of flow thereof towards the center of the substrate, or the horizontal standard line. Formation of the guide plate of this invention in the outer region is therefore successful in making the flow route uniform in an efficient manner.

More preferably, the guide plate is configured as having a first guide plate disposed on the same plane with the bank-component-side partition plate and the gas-introducing-component-side partition plate, and a second guide plate disposed outside the location of the first guide plate disposed in the width-wise direction. This configuration is successful in further exactly controlling the flow of the source gas in the width-wise direction.

It is also allowable for the vapor phase growth apparatus of this invention to be provided with an evacuation system keeping the inner space of the reaction vessel under a reduced pressure lower than the atmospheric pressure. This configuration allows epitaxial growth under a reduced pressure condition contributive to reduction in the degree of pattern deformation, when it is desired to proceed the vapor phase growth on a substrate having patterns already formed thereon.

A method of fabricating an epitaxial wafer of this invention is characterized in disposing the silicon single crystal substrate in the reaction vessel of the above-described vapor phase growth apparatus, and in allowing the source gas to flow in the reaction vessel so as to epitaxially grow the silicon single crystal film on the silicon single crystal substrate in a vapor phase, to thereby obtain an epitaxial wafer.

The silicon single crystal film can epitaxially be grown on the silicon single crystal substrate in vapor phase, by using any one gas selected from the group consisting of monochlorosilane gas, dichlorosilane gas and trichlorosilane gas as the source gas for the vapor phase epitaxial growth, while keeping the inner space of the reaction vessel under a reduced pressure lower than the atmospheric pressure.

Although the foregoing paragraph has described that the bank component is disposed as being kept in a positional relation so as to align the top surface thereof at an almost same level with the top surface of the susceptor, this does not always mean that the top surface of the bank component and the top surface of the susceptor are aligned perfectly at the same level, but allowing instead that positional difference up to 2 mm or around is understood as the same level.

### BRIEF DESCRIPTION OF THE DRAWINGS

FIG. 1 is a sectional side elevation showing an example of the vapor phase growth apparatus of this invention;
FIG. 2 is an enlarged sectional view showing an essential portion of the vapor phase growth apparatus of this invention;
FIG. 3 is a plan view of the vapor phase growth apparatus of this invention;
FIG. 4 is an exploded perspective view showing, in a partially notched manner, an essential portion of the vapor phase growth apparatus of this invention;
FIG. 5 is a sectional view showing another example of mode of disposition of the guide plates;
FIG. 6 is a perspective view showing another geometry of the guide plate;
FIG. 7 is a schematic drawing explaining flow of the source gas in the vapor phase growth apparatus of this invention;
FIG. 8 is a schematic drawing explaining flow of the source gas in a conventional vapor phase growth apparatus;
FIG. 9 is a conceptual drawing explaining a mode of flow of the source gas over the top surface of the bank component;
FIG. 10A is a drawing showing a flow route distribution of the source gas in the vapor phase growth apparatus of this invention, obtained by a computer simulation;
FIG. 10B is a drawing showing a flow route distribution of the source gas in a conventional vapor phase growth apparatus, obtained by a computer simulation;
FIG. 11A is a contour map showing a growth rate distribution in the vapor phase growth apparatus of this invention, obtained by a computer simulation; and
FIG. 11 B is a contour map showing a growth rate distribution in a conventional vapor phase growth apparatus, obtained by a computer simulation.

### BEST MODES FOR CARRYING OUT THE INVENTION

Paragraphs below will explain best modes for carrying out this invention, referring to the attached drawings.

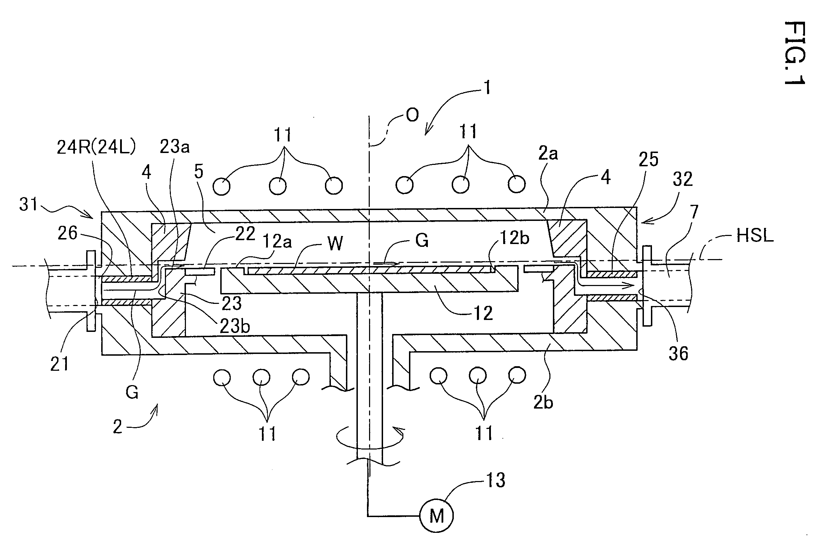

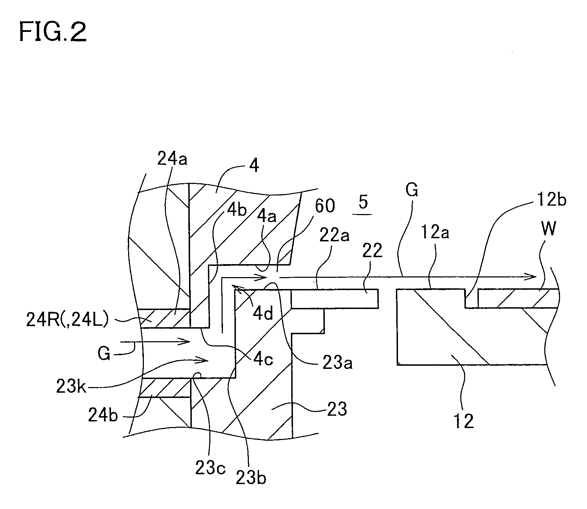

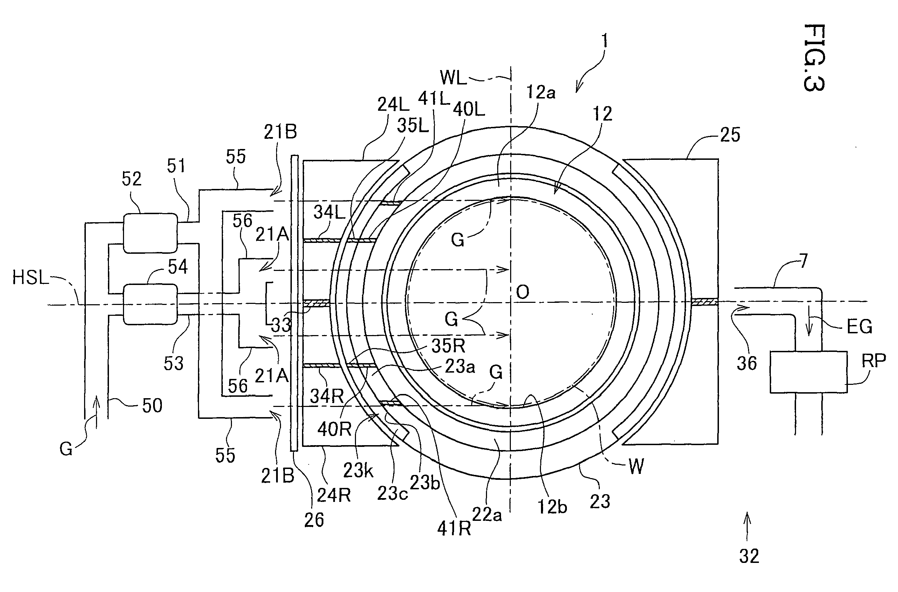

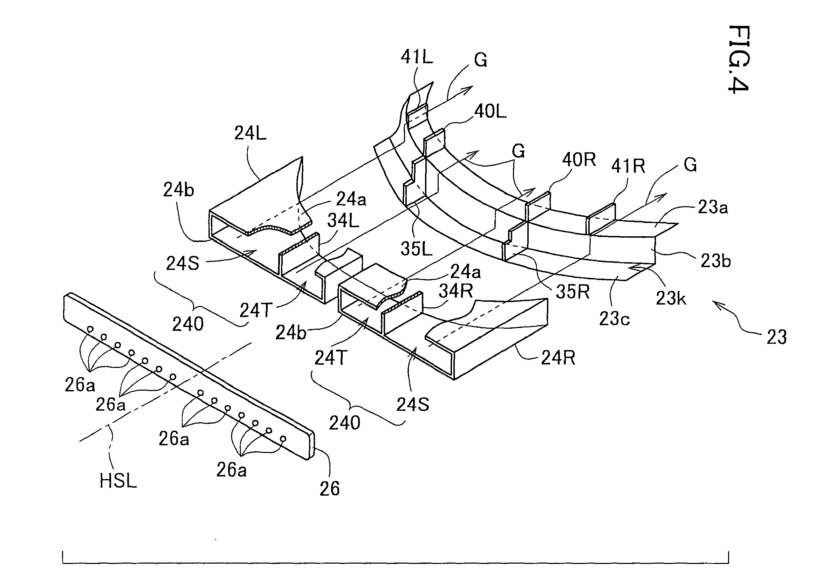

FIGs. 1 to 4 schematically show an exemplary vapor phase growth apparatus 1 of this invention, allowing vapor phase growth of a silicon single crystal film on the main surface of a silicon single crystal substrate to proceed therein. FIG. 1 is a sectional side elevation of the apparatus, FIG. 2 is an enlarged view showing a portion in the vicinity of a source gas introducing component, FIG. 3 is a plan view of the vapor phase growth apparatus 1 shown in FIG. 1, and FIG. 4 is an exploded perspective view showing, in a partially notched manner, an essential portion of the vapor phase growth apparatus 1 shown in FIG. 1. As shown in FIG. 1, the vapor phase growth apparatus 1 has a reaction vessel 2 having a gas introducing port 21 formed on a first end 31 side in the horizontal direction, and has a gas discharging port 36 on a second end 32 side of the same direction. The apparatus is configured so as to introduce a source gas G for forming the film through the gas introducing port 21 into the reaction vessel 2, allow the gas to flow in the direction along the main surface of a substrate W held in a near-horizontally rotating manner in the inner space 5 of the reaction vessel 2, and discharge the gas from the gas discharging port 36 through an exhaust duct 7. The exhaust duct 7 configures an evacuation system of the vapor phase growth apparatus 1, together with a pressure-reducing pump RP (FIG. 3).

As shown in FIG. 1, in the inner space 5 of the reaction vessel 2, there is disposed a disc-formed susceptor 12 rotatively driven by a motor 13 around a vertical axis of rotation O, and a single slice of substrate W for fabricating a silicon epitaxial wafer is disposed in a shallow spot facing 12b formed on the top surface of the susceptor 12. That is, the vapor phase growth apparatus 1 is configured as a single-wafer-type apparatus. The substrate W typically has a diameter of 100 mm or larger. On the upper and lower sides of the reaction vessel 2, infrared heating lamps 11 for heating the substrate are disposed at regular intervals corresponding to the region where the substrate W is placed.

In the internal space 5 of the reaction vessel 2, a bank component 23 is disposed so as to surround the susceptor 12, as shown in FIG. 3. The bank component 23 is disposed so as to align a top surface 23a thereof at an almost same level with a top surface 12a of the susceptor 12 (and consequently the main surface of the substrate W), as shown in FIG. 2. The gas introducing port 21 is opened, as shown in FIG. 1, so as to oppose to an outer peripheral surface 23b (also referred as a side face 23b hereinafter) of the bank component 23, so as to allow the source gas G supplied through the gas introducing port 21 to collide against the outer peripheral surface 23b of the bank component 23 and to climb up onto the top surface 23a side thereof, and then to flow along the main surface of the substrate W on the susceptor 12. In this embodiment, the outer peripheral surface 23b of the bank component 23 is configured as a cylindrical surface corresponding to the geometry of the susceptor 12. Along the inner peripheral surface of the bank component 23, a plate-formed preheating ring 22 for soaking is disposed, wherein the top surface 12a of the susceptor 12 disposed inside thereof is aligned at an almost same level with a top surface 22a (see FIG. 2) of the preheating ring 22. In the inner space 5, there is also disposed an upper lining component 4 having a diameter almost same with that of the bank component 23, at a location opposing to the bank component 23. Both of the bank component 23 and the upper lining component 4 are ring-formed components made of a quartz material.

In the vapor phase growth apparatus 1, as shown in FIG. 1, a virtual center line along the direction of flow of the source gas G, extending from the first end 31 of the reaction vessel 1 towards the second end 32, while crossing normal to the axis of rotation O of the susceptor 12, is assumed as a horizontal standard line HSL. The direction normal to both of the horizontal standard line HSL and the axis of rotation O of the susceptor 12 is assumed as a width-wise direction WL (FIG. 3).

On the top surface 23a of the bank component 23, guide plates 40R, 40L, 41 R and 41L are disposed as shown in FIGs. 3 and 4. The guide plates 40R, 40L, 41 R and 41 L are configured so as to partition the flow of the source gas G in the width-wise direction WL. Each of the guide plates 40R, 40L, 41 R and 41 L is composed of a quartz component placed on the top surface 23a of the bank component 23, and is provided so as to extend from the boundary between the top surface 23a of the bank component 23 and the outer peripheral surface 23b, towards the boundary between the bank component 23 and the preheating ring 22.

In this embodiment, each of the guide plates 40R, 40L, 41 R and 41 L is adjusted in size so that the upper edge thereof extends towards, and contacts with a lower surface 4a (also referred as a first surface 4a hereinafter) of the upper lining component 4 (see FIG.2). The flow of the source gas G from the external of the individual guide plates 40R, 40L, 41 R and 41 L to the internal (or vice versa) in the width-wise direction WL is thus inhibited. It is, however, allowable to form a slight gap between each of the upper edges of the guide plates 40R, 40L, 41 R and 41 L and the lower surface 4a of the upper lining component 4, for the purpose of fine adjustment. It is also allowable to fix the position of each of the guide plates 40R, 40L, 41 R and 41 L in a detachable manner into a groove formed on the top surface 23a of the bank component 23. Such configuration facilitates increase or decrease in the number of guide plates.

It is also allowable to fix the guide plates on the upper lining component 4 side. More specifically, as shown in FIG. 5, a guide plate 43 can be provided in a form of vertically drooping from the lower surface 4a of the upper lining component 4 towards the upper surface 23a of the bank component 23. The guide plate 43 may be adjusted in size so as to form a slight gap SH between itself and the bank component 23.

Each of the guide plates 40R, 40L, 41 R and 41 L is disposed so as to divide the flow of the source gas G on the top surface 23a of the bank component 23 into the sides closer to, and more distant from the horizontal standard line HSL. In the embodiment shown in FIGs. 3 and 4, the guide plates 40R and 40L, and the guide plates 41 R and 41 L are respectively provided as a pair symmetrical with respect to the horizontal standard line HSL. Each of the guide plates 40R, 40L, 41 R and 41L is also disposed so as to align the plate surface thereof in parallel with the axis of rotation of the susceptor 12 and with the horizontal standard line HSL.

As shown in FIG. 3, gas introducing components 24R, 24L, introducing the source gas G supplied through gas introducing ports 21A, 21 B towards the outer peripheral surface 23b of the bank component 23, are disposed between the gas introducing port 21 (21A, 21 B) and the bank component 23 as being symmetrically distributed with respect to the horizontal standard line HSL on both sides thereof (more specifically, on the left and right of a pillar 33 of the reaction vessel 2). Gas introducing components 24R, 24L are further provided with, in each of gas introducing spaces 240, 240 (FIG. 4) formed inside thereof, gas-introducing-component-side partition plates 34R, 34L further partitioning the flow of the source gas G in the width-wise direction WL. By such configuration, the gas introducing spaces 240, 240 are divided into gas introducing spaces 24T, 24T closer to the horizontal standard line HSL and gas introducing spaces 24S, 24S more distant from the horizontal standard line HSL.

On the other hand, on the outer peripheral surface 23b of the bank component 23, as shown in FIG. 3, there are disposed bank-component-side partition plates 35R, 35L partitioning the flow of the source gas G into a plurality of streams in the width-wise direction WL, disposed as being symmetrically distributed with respect to the horizontal standard line HSL. The source gas G tends to escape in the width-wise direction WL when it climbs up onto the top surface 23a of the bank component 23. Provision of the bank-component-side partition plates 35R, 35L together with the above-described gas-introducing-component-side partition plates 34R, 34L is successful in controlling the flow of the source gas G in the width-wise direction WL. In this embodiment, the bank-component-side partition plates 35R, 35L are disposed each on both sides of the horizontal standard line HSL. Therefore, a resultant form of disposition is such as having the gas-introducing-component-side partition plates 34R, 34L and the bank-component-side partition plates 35R, 35L respectively aligned on the same plane in parallel with the horizontal standard line HSL and the axis of rotation O.

As shown in FIG. 3, the gas introducing ports 21A, 21 B are formed so as to correspond with the gas introducing components 24R, 24L, respectively. A gas duct 50 branches into an inner duct 53 supplying the gas towards the gas introducing spaces 24T (FIG. 4) closer to the horizontal standard line HSL and an outer duct 51 supplying gas towards the gas introducing spaces 24S (FIG. 4) more distant from the horizontal standard line HSL, allowing independent control of flow rate of the source gas G respectively by mass flow controllers (MFC) 54, 52. It is also allowable herein to use manual valves in place of the MFCs 54, 52. The inner duct 53 and the outer duct 51 are further divided into branched ducts 56, 56 and branched ducts 55, 55, respectively, having inner gas introducing ports 21A, 21A and outer gas introducing ports 21 B, 21 B opened on each side of the horizontal standard line HSL.

As shown in FIG. 4, the gas introducing components 24R, 24L are quartz-made cylindrical components each having an oblong section, and being opened respectively on the gas introducing port 21 side and on the bank component side 23. The gas-introducing-component-side partition plates 34R, 34L are disposed respectively in the individual inner spaces of the gas introducing components 24R, 24L, so as to extend from top plates 24a and bottom plates 24b disposed nearly in parallel to each other. By virtue of such disposition of the gas introducing components 24R, 24L, integrated with the gas-introducing-component-side partition plates 34R, 34L, in a detachable manner with respect to the reaction vessel 2, any alteration for example of location of the gas-introducing-component-side partition plates 34R, 34L can readily be accomplished simply by exchanging the gas introducing components 24R, 24L.

As known from FIGs. 3 and 4, the bank-component-side partition plate 35R and the gas-introducing-component-side partition plate 34R are disposed on the same plane in parallel with both of the horizontal standard line HSL and the axis of rotation O of the susceptor 12, and the guide plate 41 R is disposed at a location more distant from the horizontal standard line HSL than that of such plane, in other words, on the outer side in the width-wise direction WL. Similarly, the bank-component-side partition plate 35L and the gas-introducing-component-side partition plate 34L are disposed on the same plane in parallel with both of the horizontal standard line HSL and the axis of rotation O of the susceptor 12, and the guide plate 41 L is disposed at a location more distant from the horizontal standard line HSL than that of such plane. In this embodiment, one guide plate 40R, out of the pair of guide plates 40R, 40L, is disposed on the same plane with the bank-component-side partition plate 35R and the gas-introducing-component-side partition plate 34R, and similarly the other guide plate 40L is disposed on the same plane with the bank-component-side partition plate 35L and the gas-introducing-component-side partition plate 34L. It is, therefore, understood that another pair of the guide plates 41 R, 41 L is disposed outside the guide plates 40R, 40L in the width-wise direction WL. This mode of disposition is suitable for controlling the flow of the source gas G in the width-wise direction WL.

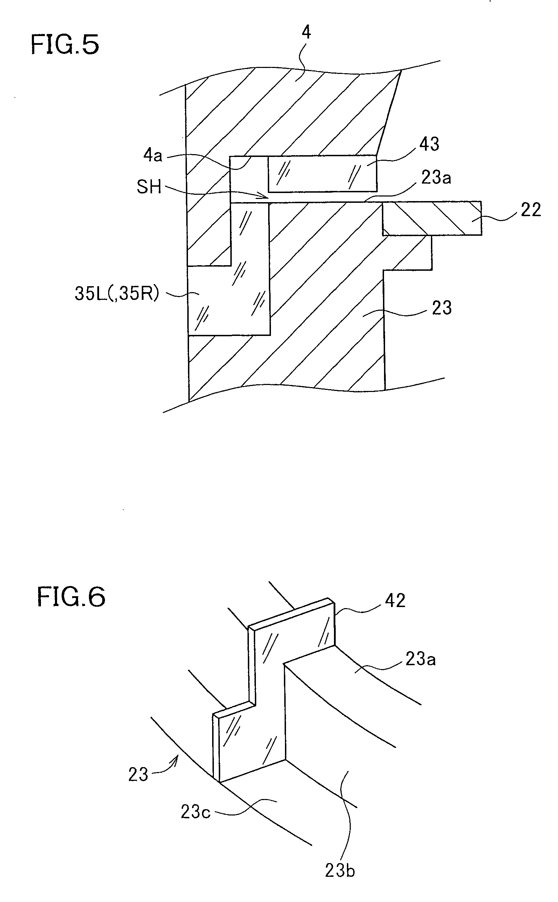

The bank-component-side partition plates 35R, 35L herein may be fabricated as being integrated with the guide plates 40R, 40L. More specifically, as shown in FIG. 6, a guide plate 42 having a crank geometry which coincide with a profile of a gas passageway 60 (see FIG. 2) formed between the bank component 23 and the upper lining component 4 can be exemplified.

The bank component 23 herein has a bow-formed notched portion 23k, as shown in FIG. 4, formed by notching the outer peripheral portion of the top surface 23a of the bank component 23 in a recess-forming manner, in a sector opposing to the gas introducing components 24R, 24L. The reaction vessel 2 is composed of a lower vessel 2b and an upper vessel 2a as shown in FIG. 1, and the upper lining component 4 and the bank component 23 are disposed along the inner peripheral surfaces of the upper vessel 2a and the lower vessel 2b, respectively. As shown in FIG. 2, a bottom surface 23c of the notched portion 23k is aligned at an almost same level with an extension of the inner surfaces of the bottom plates 24b of the gas introducing components 24R, 24L, and plays a role of a gas introducing surface. The source gas G collides against the side face 23b of the notched portion 23k (outer peripheral surface of the bank component 23), and climbs up onto the top surface 23a. The upper lining component 4 has a step portion 4d composed of the first surface 4a opposing to the top surface 23a of the bank component 23, a second surface 4b opposing to the side face 23b of the notched portion 23k, and a third surface opposing to the bottom surface 23c of the same, so as to form, between itself and the notched portion 23k, the crank-formed gas passageway 60. As shown in FIG. 4, the bank-component-side partition plates 35R, 35L are formed with an L-shape conforming to the profile of the gas passageway 60.

As shown in FIG. 3, a baffle 26 is disposed between the gas introducing ports 21A, 21 B and the gas introducing component 24R, 24L. The baffle 26 is formed with an oblong geometry corresponded to the openings of the gas introducing components 24R, 24L as shown in FIG. 4, and has a plurality of gas passage holes 26a formed therein at regular intervals in the longitudinal direction. As shown in FIG. 3, a discharge-side gas introducing component 25 is disposed between the bank component 23 and the gas discharging port 36.

Paragraphs below will describe a method of fabricating an epitaxial wafer using the above-described vapor phase growth apparatus 1. As shown in FIGs. 1 to 4, the substrate W is placed on the susceptor 12 in the reaction vessel 2, subjected to a pretreatment such as removal of a native oxide film if necessary, and heated under rotation to a predetermined reaction temperature using the infrared heating lamps 11. While keeping the condition unchanged, the source gas G is allowed to flow through the individual gas introducing ports 21A , 21 B into the reaction vessel 2 at a predetermined flow rate, so as to proceed epitaxial growth of a silicon single crystal film on the substrate W, to thereby obtain an epitaxial wafer.

The source gas G is used for the vapor phase growth of the silicon single crystal film on the substrate W, and is selected from silicon compounds such as SiHCl₃, SiCl₄, SiH₂Cl₂, SiH₄ and so forth. The source gas G is appropriately compounded with B₂H₆ or PH₃ as a dopant gas, or with H₂ as a dilution gas. For the case where the native oxide is removed in advance of the vapor phase growth of the film, a pretreatment gas prepared by diluting a corrosive gas such as HCl with a dilution gas is supplied into the reaction vessel 2, or the substrate W is subjected to high-temperature annealing in a H₂ atmosphere.

Operations expectable during the flow of the source gas G in the reaction vessel 2 will be explained below. As indicated by the dashed line with an arrow head in the plan view of FIG. 3, the source gas G flows through the baffle 26 and the gas introducing components 24R, 24L towards the outer peripheral surface 23b of the bank component 23. The source gas G collided against the outer peripheral surface 23b of the bank component 23 then climbs up onto the top surface 23a of the bank component 23, and flows along the main surface of the substrate W. Exhaust gas EG is collected by the discharge-side gas introducing component 25 into the discharge duct 7, and then discharged.

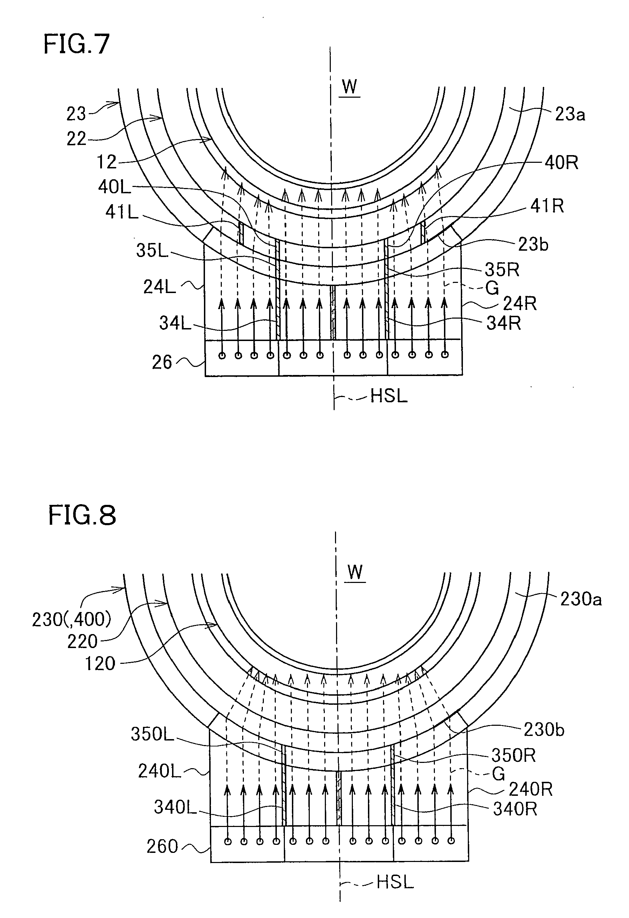

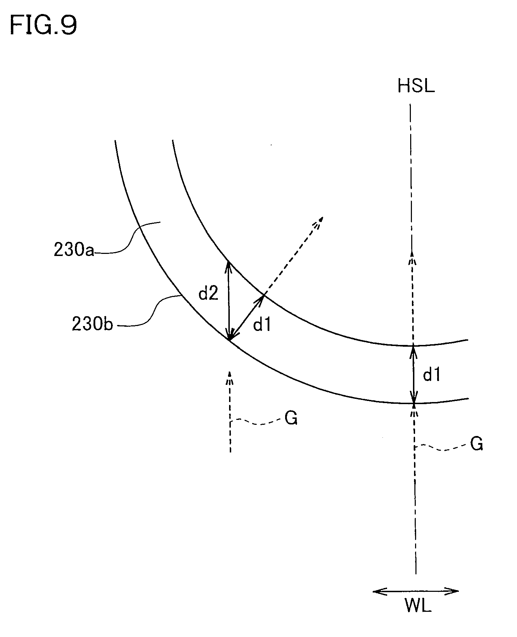

FIG. 8 shows a conventional vapor phase growth apparatus having no guide plates 40R, 40L, 41 R, 41 L disposed therein. Any components corresponding with those of the vapor phase growth apparatus 1 of this invention are given with reference numerals each having an additional zero. In the conventional vapor phase growth apparatus, the source gas G advances via a preheating ring 220 onto a susceptor 120, showing a tendency of approaching towards the center of the substrate, or approaching the horizontal standard line HSL. This is because the source gas G tends to flow in the direction possibly minimizing resistance, when it passes through the gas passageway (corresponded to reference numeral 60 in the apparatus of this invention shown in FIG. 2), formed between a bank component 230 and an upper lining component 400. Because the bank component 230 has a ring-like geometry, as shown in the conceptual drawing of Figs.9, linear path d2 of the source gas G flowing across the top surface 230a of the bank component 230 is larger than the shortest path d1 directed to the center of the substrate. In other words, the resistance exerted on the source gas G advancing towards the susceptor can be minimized when the gas passes over a top surface 230a of the bank component 230 along the shortest path d1. It is also noted that the linear path d2 becomes longer as distanced more largely from the horizontal standard line HSL, because the bank component 230 and the upper lining component 400 respectively have a ring geometry. As a consequence, stream of the source gas G more distant from the horizontal standard line HSL, or more closer to the both edge regions in the width-wise direction WL, more largely varies the direction of flow thereof on the top surface 230a of the bank component 230 towards the center of the substrate.

When the flow velocity of the source gas G is not so large, the gas after climbing over the bank component 230 is once directed towards the center of the substrate, but immediately changes the direction of the flow to the downstream direction, due to an elevated pressure in the vicinity of the horizontal standard line HSL where the streams concentrate. Therefore, the event that the source gas G after climbing over the bank component 230 is once directed towards the center of the substrate will be of no critical issue, when the flow velocity of the source gas G is not so large. On the contrary, when the flow velocity of the source gas G is large, the momentum of the gas is large, thus the streams will not change their directions to the downstream direction up to positions showing the pressure in the vicinity of the horizontal standard line HSL, where the streams concentrate, elevated enough. In other words, the travel path towards the center of the substrate grows longer. As a consequence, the event that the source gas G after climbing over the bank component 230 is once directed towards the center of the substrate will result in a larger effect, when the flow velocity of the source gas G is large.

In the epitaxial growth of the silicon single crystal film in the reaction vessel having a pressure conditioned lower than the atmospheric pressure (so-called, reduced-pressure epitaxial growth), the flow velocity of the source gas G flowing through the reaction vessel is several times faster than in the normal-pressure epitaxial growth. Therefore, in particular in the reduced-pressure epitaxial growth, the event that the source gas G after climbing over the bank component 230 is once directed towards the center of the substrate becomes not negligible.

In contrast to this, the vapor phase growth apparatus 1 of this invention has the guide plates 40R, 40L, 41 R, 41 L, partitioning the flow of the source gas G in the width-wise direction, disposed on the top surface 23a of the bank component 23. The source gas G can therefore flow onto the susceptor 12 in a near-straightforward manner, as being controlled in the flow thereof in the width-wise direction WL even after climbing up the bank component 23, as shown in FIG. 7. This successfully ensures a uniform flow route over the substrate W.

### Experimental Cases

### (Computer Simulation Experiments)

A flow route of the source gas in the vapor phase growth apparatus 1 as shown in FIGs. 1 to 4 was found by computer simulation. For the comparative purpose, also a flow route of the source gas in a conventional vapor phase growth apparatus having no guide plates 40R, 40L, 41 R, 41 L was found. A growth rate distribution of the silicon single crystal film when it is epitaxially grown on the silicon single crystal substrate W in the vapor phase growth apparatus shown in FIGs. 1 to 4 was estimated by computer simulation. For the comparative purpose, also a growth rate distribution of the silicon single crystal film when it is epitaxially grown on the silicon single crystal substrate in the conventional vapor phase growth apparatus having no guide plates 40R, 40L, 41 R, 41 L was estimated. Set conditions were as listed below.
Software: Fluent Ver 6.0 (product of Fluent Asia Pacific Co., Ltd.)
(Dimensions)
· Diameter of reaction vessel= 300 mm
· Height of reaction vessel (distance from the susceptor 12 to the inner top surface of the reaction vessel 2)= 20 mm
· Height of bank component (distance from the bottom surface 23c of the notched portion 23k to the top surface 23a of the bank component 23)= 16 mm
· Diameter of silicon single crystal substrate= 200 mm
(Growth Temperature)
· Silicon single crystal substrate: 1400 K
· Top surface of reaction vessel : 700 K
(Pressure in Reaction Vessel)
· 10000 Pa
(Source Gas)
· Trichlorosilane: 1.5 mol%
· Hydrogen: 98.5 mol%
(Flow Rate of Source Gas)
· Inner Introduction Path: 13.5 L/min (standard state)
· Outer Introduction Path: 13.5 L/min (standard state)

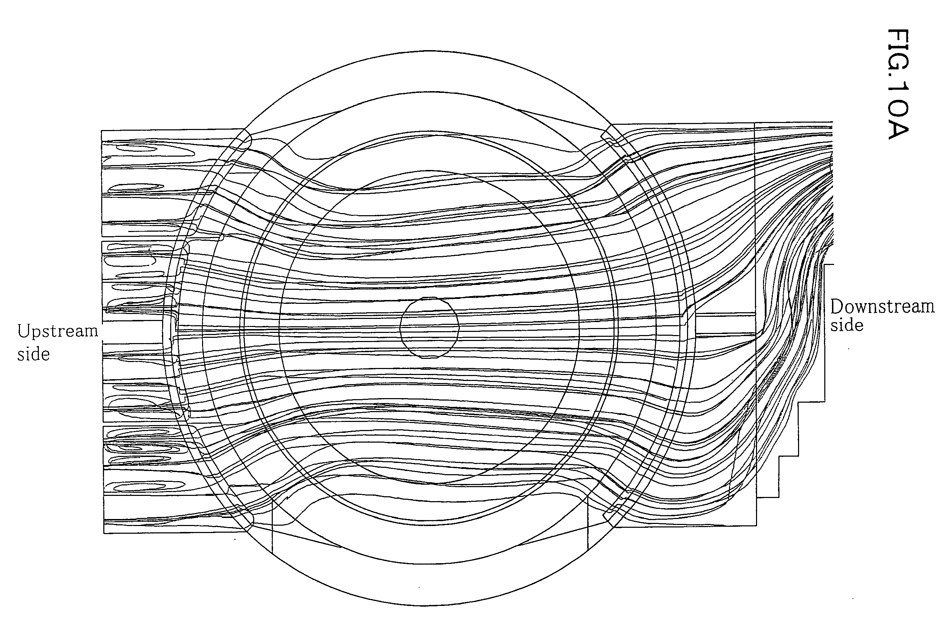

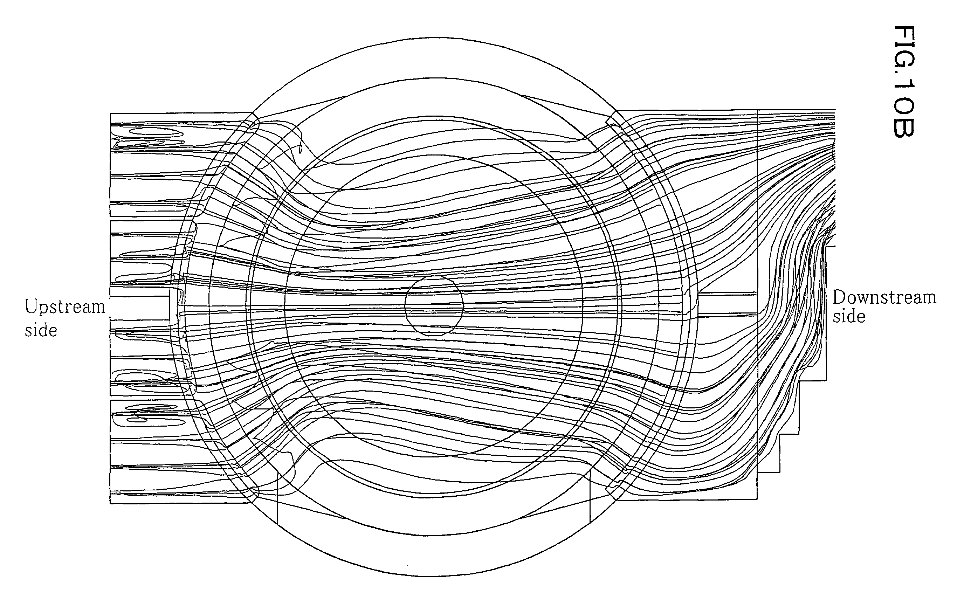

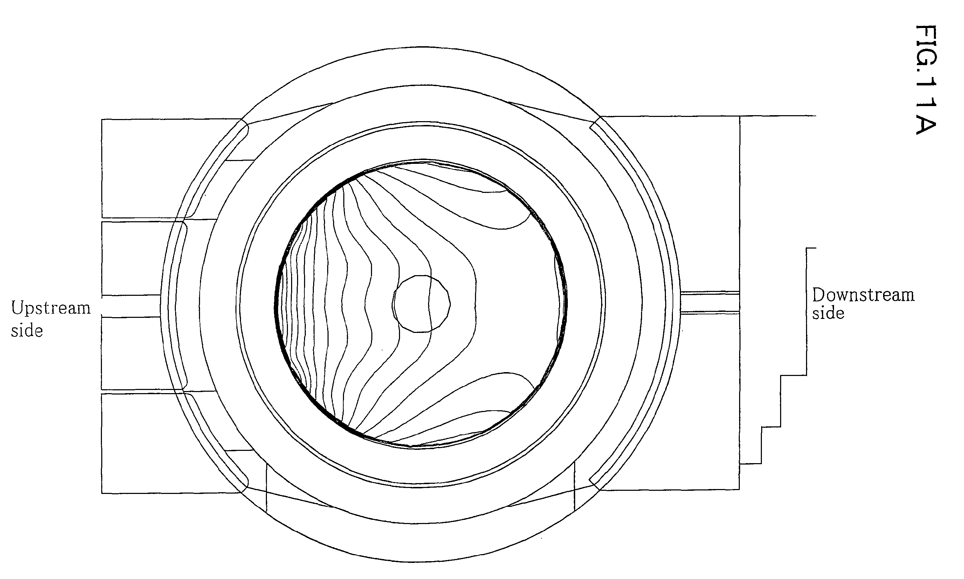

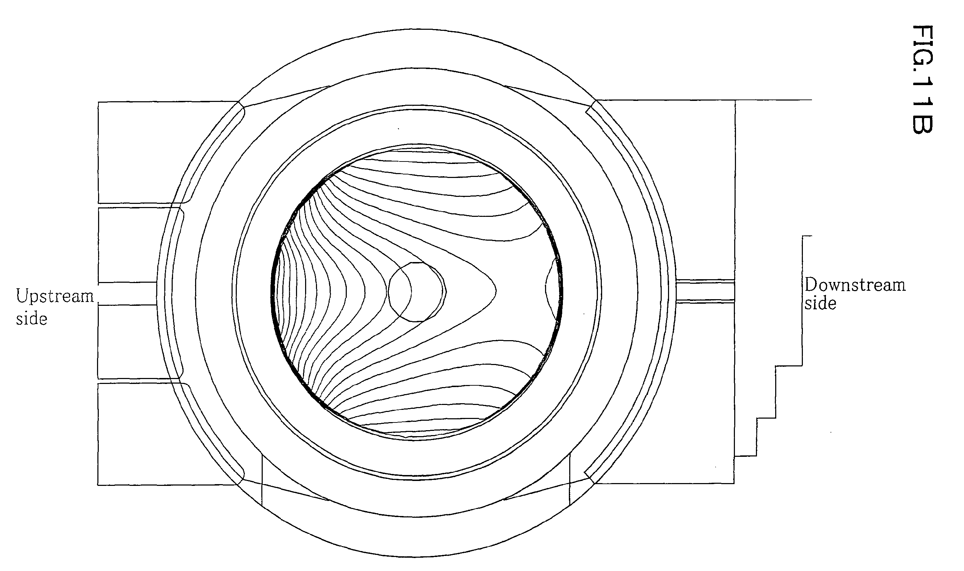

FIGs. 10A and 10B are drawings showing the flow routes of the source gas G obtained by the computer simulation, and FIGs. 11A and 11 B are contour maps showing growth rate distributions of the silicon single crystal film. FIGs. 10A and 11A correspond to the cases using the vapor phase growth apparatus 1 of this invention, and FIGs. 10B and 11 B correspond to the cases using the conventional vapor phase growth apparatus.

First as seen in FIG. 10A, the source gas G in the vapor phase growth apparatus 1 of this invention having the guide plates 40R, 40L, 41 R, 41 L shows only a small tendency of approaching towards the center of the substrate (horizontal standard line). On the other hand, the source gas G in the conventional vapor phase growth apparatus having no guide plates 40R, 40L, 41 R, 41 L shows a large deflection in the direction of the flow over the top surface 23a of the bank component 23.

The contour maps of the growth rate distribution as seen next in FIGs. 11A and 11 B show the contours indicating slower growth rates as the flow advances towards the downstream side, because it is assumed herein that the silicon single crystal substrate W is not rotated. The contours in the conventional vapor phase growth apparatus show a large waving, whereas the contours in the vapor phase growth apparatus 1 of this invention are found to show only a small rippling.

## Claims

1. A vapor phase growth apparatus allowing vapor phase growth of a silicon single crystal film on the main surface of a silicon single crystal substrate to proceed therein,
having a reaction vessel having a gas introducing port formed on a first end side in a horizontal direction, and having a gas discharging port on a second end side in the same direction, configured as allowing a source gas for forming the silicon single crystal film to be introduced through the gas introducing port into the reaction vessel, and to flow along the main surface of the silicon single crystal substrate held in a near-horizontally rotating manner in the inner space of the reaction vessel, and to be discharged through the gas discharging port, the silicon single crystal substrate being disposed on a disc-formed susceptor rotated in the inner space, and having a bank component disposed so as to surround the susceptor, and kept in a positional relation so as to align the top surface thereof at an almost same level with the top surface of the susceptor, and
further configured so that the gas introducing port is opened so as to oppose to a outer peripheral surface of the bank component, so as to allow the source gas supplied through the gas introducing port to collide against the outer peripheral surface of the bank component and to climb up onto the top surface side thereof, and then to flow along the main surface of the silicon single crystal substrate on the susceptor,
wherein, assuming a virtual center line along the direction of flow of the source gas, extending from the first end of the reaction vessel towards the second end, while crossing normal to the axis of rotation of the susceptor, as the horizontal standard line, and also assuming the direction normal to both of the axis of rotation of the susceptor and the horizontal standard line as the width-wise direction,
a guide component dividing the flow of the source gas in the width-wise direction is disposed on the top surface of the bank component.

2. The vapor phase growth apparatus as claimed in Claim 1,
wherein the guide component is configured so as to prevent the source gas from approaching the horizontal standard line.

3. The vapor phase growth apparatus as claimed in Claim 1 or 2,
wherein the guide component is a guide plate dividing the flow of the source gas into sides closer to, and more distant from the horizontal standard line.

4. The vapor phase growth apparatus as claimed in Claim 3,
wherein the guide plate is disposed so as to align the plate surface thereof in parallel with the axis of rotation of the susceptor and with the horizontal standard line.

5. The vapor phase growth apparatus as claimed in Claim 3 or 4, having a gas introducing component, introducing the source gas supplied through the gas introducing port towards the outer peripheral surface of the bank component, disposed between the gas introducing port and the bank component as being symmetrically distributed with respect to the horizontal standard line in the width-wise direction, the gas introducing component having, in each of gas introducing spaces formed inside thereof, a gas-introducing-component-side partition plate partitioning the flow of the source gas in the width-wise direction, and
having, on the outer peripheral surface of the bank component, a bank-component-side partition plate, partitioning the flow of the source gas into a plurality of streams in the width-wise direction, disposed as being symmetrically distributed with respect to the horizontal standard line.

6. The vapor phase growth apparatus as claimed in Claim 5,
wherein the guide plate is disposed outside the locations of the bank-component-side partition plate and the gas-introducing-component-side partition plate disposed, in the width-wise direction.

7. The vapor phase growth apparatus as claimed in Claim 5,
wherein the guide plate is configured as having a first guide plate disposed on the same plane with the bank-component-side partition plate and the gas-introducing-component-side partition plate, and a second guide plate disposed outside the location of the first guide plate disposed in the width-wise direction.

8. The vapor phase growth apparatus as claimed in any one of Claims 1 to 7, further having an evacuation system keeping the inner space of the reaction vessel under a reduced pressure lower than the atmospheric pressure.

9. A method of fabricating an epitaxial wafer disposing the silicon single crystal substrate in the reaction vessel of the vapor phase growth apparatus described in any one of Claims 1 to 8, allowing a source gas to flow in the reaction vessel so as to epitaxially grow a silicon single crystal film on the silicon single crystal substrate in a vapor phase, to thereby obtain an epitaxial wafer.

10. The method of fabricating an epitaxial wafer as claimed in Claim 9, wherein the silicon single crystal film is epitaxially grown on the silicon single crystal substrate in vapor phase, by using any one gas selected from the group consisting of monochlorosilane gas, dichlorosilane gas and trichlorosilane gas as the source gas, while keeping the inner space of the reaction vessel under a reduced pressure lower than the atmospheric pressure.
